(19) Europäisches Patentamt
European Patent Office
Office européen des brevets

(11) **EP 1 769 540 B1**

(12) **EUROPÄISCHE PATENTSCHRIFT**

(45) Veröffentlichungstag und Bekanntmachung des Hinweises auf die Patenterteilung:
**23.09.2009 Patentblatt 2009/39**

(51) Int Cl.:
**H01L 33/00** *(2006.01)*

(21) Anmeldenummer: **05761634.4**

(22) Anmeldetag: **29.06.2005**

(86) Internationale Anmeldenummer:
**PCT/DE2005/001148**

(87) Internationale Veröffentlichungsnummer:
**WO 2006/002614 (12.01.2006 Gazette 2006/02)**

(54) **REFLEKTIERENDES SCHICHTSYSTEM MIT EINER MEHRZAHL VON SCHICHTEN ZUR AUFBRINGUNG AUF EIN III/V-VERBINDUNGSHALBLEITERMATERIAL**

REFLECTIVE LAYERED SYSTEM COMPRISING A PLURALITY OF LAYERS THAT ARE TO BE APPLIED TO A III-V COMPOUND SEMICONDUCTOR MATERIAL

SYSTEME DE COUCHES REFLECHISSANTES COMPORTANT UNE PLURALITE DE COUCHES, DESTINE A ETRE APPLIQUE SUR UN MATERIAU SEMI-CONDUCTEUR COMPOSE III/V

(84) Benannte Vertragsstaaten:
**DE**

(30) Priorität: **30.06.2004 DE 102004031684**
**19.08.2004 DE 102004040277**

(43) Veröffentlichungstag der Anmeldung:
**04.04.2007 Patentblatt 2007/14**

(73) Patentinhaber: **OSRAM Opto Semiconductors GmbH**
**93055 Regensburg (DE)**

(72) Erfinder:
• **KRÄUTER, Gertrud**
**93051 Regensburg (DE)**
• **PLÖSSL, Andreas**
**93051 Regensburg (DE)**
• **WIRTH, Ralph**
**93186 Pettendorf-Adlersberg (DE)**
• **ZULL, Heribert**
**93049 Regensburg (DE)**

(74) Vertreter: **Epping - Hermann - Fischer Patentanwaltsgesellschaft mbH**
**Ridlerstrasse 55**
**80339 München (DE)**

(56) Entgegenhaltungen:
**US-A- 4 122 486          US-A- 4 142 160**
**US-A- 4 213 805**

• **PATENT ABSTRACTS OF JAPAN Bd. 2000, Nr. 07, 29. September 2000 (2000-09-29) & JP 2000 106454 A (INTERUNIV MICRO ELECTRONICA CENTRUM VZW; UNIV BRUXELLES), 11. April 2000 (2000-04-11)**
• **BALIGA B J ET AL: "Lateral diffusion of zinc and tin in gallium arsenide" IEEE TRANSACTIONS ON ELECTRON DEVICES USA, Bd. ED-21, Nr. 7, Juli 1974 (1974-07), Seiten 410-415, XP002351219 ISSN: 0018-9383 in der Anmeldung erwähnt**

**Beschreibung**

Die Erfindung betrifft ein reflektierendes Schichtsystem mit einer Mehrzahl von Schichten aufgebracht auf Verbindungshalbleitermaterialien für optoelektronische Halbleiterchips.

Sowohl auf den Außenflächen als auch im Innern optoelektronischer Halbleiterchips befinden sich häufig spiegelnde Schichten zum Umlenken von Lichtstrahlen, wobei meist eine hohe Reflektivität der spiegelnden Schichten in alle Raumrichtungen erwünscht ist. Als Maß hierfür kann die integrale Reflektivität $R_{int}$ dienen. Hierbei handelt es sich um das normierte Integral der von dem Schichtsystem reflektierten Intensität $R(\vartheta)$ über den Winkelbereich, in den reflektiert wird:

$$R_{int} = \int_0^{\pi/2} R(\vartheta) \sin \vartheta d\vartheta \Big/ \int_0^{\pi/2} \sin \vartheta d\vartheta$$

Um spiegelnde Schichten mit einer hohen Reflektivität über alle Raumwinkel zu erhalten, können neben reinen Metallschichten auch Kombinationen aus dielektrischen Schichten mit niedrigem Brechungsindex und reflektierenden Metallschichten eingesetzt werden.

Auf Grund seines Brechungsindexes kann als Material für die dielektrische Schicht beispielsweise Siliziumdioxid verwendet werden. Für den Aufbau eines reflektierenden Schichtsystems auf einem III/V-Verbindungshalbleitermaterial besitzt Siliziumdioxid jedoch den Nachteil, dass dessen thermischer Ausdehnungskoeffizient deutlich anders ist, als der von III/V-Verbindungshalbleitern, was zu Haftungsproblemen führen kann.

Die Druckschrift US 4,122,486 offenbart eine Leuchtdiode mit einer Phosphor-Silikatglasschicht und einer Goldschicht.

Aufgabe der vorliegenden Erfindung ist es, ein reflektierendes Schichtsystem mit optimierter integraler Reflektivität und optimierter Stabilität aufgebracht auf ein Verbindungshalbleitermaterial und ein Verfahren zur Herstellung eines solchen anzugeben.

Diese Aufgaben werden durch ein reflektierendes Schichtsystem mit den Merkmalen des Patentanspruches 1 gelöst.

Vorteilhafte Weiterbildungen des reflektierenden Schichtsystems sind in den Unteransprüchen angegeben.

Bei einem reflektierenden Schichtsystem gemäß der Erfindung befindet sich eine dielektrische Schicht, die Phosphosilikatglas (PSG) enthält, auf der mit dem reflektierenden Schichtsystem zu versehenden III/V-Verbindungshalbleiteroberfläche. Von der III/V-Verbindungshalbleiteroberfläche aus gesehen folgt auf die dielektrische Schicht, vorzugsweise direkt, eine weitere metallische Schicht. Vorzugsweise befindet sich die dielektrische Schicht unmittelbar auf dieser III/V-verbindungshalbleiteroberfläche.

Auf dem Schichtsystem können sich auch weitere Schichten befinden, wie beispielsweise eine Schicht, die Gold enthält, und zur Verbindung der Oberfläche des reflektierenden Schichtsystems mit einer anderen Oberfläche durch Beaufschlagung mit Druck und Temperatur dienen kann.

Im Vergleich zu einer reinen Siliziumdioxidschicht besitzt die dielektrische Schicht, die Phosphosilikatglas enthält, den Vorteil, dass ihr thermischer Ausdehnungskoeffizient durch Variation des Phosphatgehaltes geändert werden kann. So kann der thermische Ausdehnungskoeffizient der dielektrischen Schicht insbesondere an den des III/V-Verbindungshalbleiters angepasst werden. Hierdurch werden Haftungsprobleme vermieden, die beispielweise bei reinen Siliziumdioxidschichten auf III/V-Verbindungshalbleiteroberflächen auf Grund der unterschiedlichen thermischen Ausdehnungskoeffizienten entstehen können.

Gleichzeitig unterscheidet sich der Brechungsindex einer Schicht, die Phosphosilikatglas enthält, nicht wesentlich von dem einer reinen Siliziumdioxidschicht, wie der Druckschrift mit dem Titel "Physical Properties of Phosphorus-Silica Glass in Fiber Preforms" (Journal of Communications Technology and Electronics, 1998, 43, 4, S. 480-484) zu entnehmen ist.

Ein derart ausgebildetes reflektierendes Schichtsystem besitzt eine optimierte integrale Reflektivität bei gleichzeitig hinreichender mechanischer Stabilität.

Zwischen der dielektrischen Schicht, die Phosphosilikatglas enthält und dem III/V-Verbindungshalbleitersubstrat können sich auch weitere Schichten aus einigen Moleküllagen befinden, beispielsweise zur Haftvermittlung.

Das reflektierende Schichtsystem kann auch auf anderen Materialien aufgebracht werden, deren optische Eigenschaften denen von III/V-Verbindungshalbleitermaterialien ähnlich sind, wie beispielsweise Zinkselenid.

Zwischen der dielektrischen Schicht und der metallischen Schicht befindet sich eine Kapselungsschicht, die die dielektrische Schicht gegenüber der Chipumgebung kapselt und so vor Feuchtigkeit weitestgehend schützt. Da Phosphosilikatglas auf Grund seines Phosphatanteiles stark hygroskopisch ist, wodurch es in Verbindung mit Wasser zu der Entstehung von Phosphorsäure kommen kann, kann dies insbesondere dann sinnvoll sein, wenn die metallische Schicht prozesstechnisch nicht zügig genug direkt auf die dielektrische Schicht aufgebracht werden kann.

Bevorzugt enthält die Kapselungsschicht Siliziumnitrid, nicht notwendigerweise stöchiometrisch, oder $SiO_xN_y$, wobei gilt $x,y \in [0;1]$ und x+y=1. Diese Materialien bieten den Vorteil, dass sie weitestgehend durchlässig für die zu reflektierende elektromagnetische Strahlung sind und einen guten Haftungsgrund für eine darauffolgende metallische Schicht darstellen.

Bei einer besonders bevorzugten Ausführungsform eines reflektierenden Schichtsystems ist der Phosphatgehalt der dielektrischen Schicht so ausgewählt, dass deren thermischer Ausdehnungskoeffizient an den des III/V-Verbindungshalbleitermaterials angepasst ist, was die Haftungseigenschaften vorteilhafterweise wesentlich verbessert.

Bei einer weiterhin besonders bevorzugten Ausführungsform eines reflektierenden Schichtsystems enthält die metallische Schicht mindestens ein Material aus der Gruppe bestehend aus Gold, Zink, Silber und Aluminium.

Es ist möglich, dass sich unter der metallischen Schicht eine weitere Schicht zur Haftvermittlung befindet. Eine solche Haftvermittlungsschicht enthält bevorzugt Cr oder Ti.

Vorzugsweise befindet sich eine vierte Sperrschicht, die TiW:N umfasst, auf der Metallschicht des reflektierenden Schichtsystems. TiW:N bezeichnet in diesem Zusammenhang ein Schichtmaterial, das dadurch gebildet wird, dass die Materialien Ti und W gleichzeitig in einer Stickstoffatmosphäre auf eine Oberfläche aufgebracht werden. Alternativ oder zusätzlich können Sperrschichten auch Ni, Nb, Pt, Ni:V, TaN oder TiN enthalten.

Die Sperrschicht hat die Aufgabe zumindest einzelne Schichten des darunter liegenden reflektierenden Schichtsystems vor schädigenden Einflüssen aus der Umgebung oder durch weitere Prozesse zu schützen. So kann eine solche Schicht beispielsweise als Schutz vor dem Kontakt des reflektierenden Schichtsystems mit Metallschmelzen aufgebracht werden, der etwa während späteren Lötvorgängen erfolgen könnte. Alternativ kann die Sperrschicht auch eine Barriere gegen Feuchtigkeit aus der Umgebung darstellen. Dies ist beispielsweise sinnvoll, wenn eine der unteren Schichten Silber enthält, um Silbermigration vorzubeugen.

Bevorzugt sind zur elektrischen Kontaktierung elektrisch leitfähige Kontaktstellen durch das reflektierende Schichtsystem hindurch ausgebildet, die eine elektrisch leitfähige Verbindung von dem III/V-Halbleitermaterial durch alle isolierenden Schichten herstellen. Hierdurch kann beispielsweise die aktive Schichtenfolge eines Dünnfilm-LED-Chips rückseitig elektrisch kontaktiert werden.

Weiterhin können einzelne oder alle Schichten des reflektierenden Schichtsystems bei einer vorteilhaften Ausführungsform der Erfindung nur auf Teilbereichen der III/V-Halbleiteroberfläche ausgebildet sein. Auf diese Weise ist das reflektierende Schichtsystem nur dort vollständig ausgebildet, wo es die Funktion des Chips erfordert. Ist die III/V-Halbleiteroberfläche strukturiert, können die Schichten auch dieser Strukturierung folgend aufgebracht sein.

Besonders bevorzugt wird das reflektierende Schichtsystem auf ein III/V-Verbindungshalbleitermaterial auf der Basis von GaN, GaP oder GaAs aufgebracht.

Ein "III/V-Verbindungshalbleitermaterialien auf der Basis von GaN" bedeutet in diesem Zusammenhang, dass ein derart bezeichnetes Material vorzugsweise $Al_nGa_mIn_{1-n-m}N$ umfasst, wobei $0 \leq n \leq 1$, $0 \leq m \leq 1$ und $n+m \leq 1$. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des Materials im Wesentlichen nicht ändern. Obige Formel beinhaltet der Einfachheit halber jedoch nur die wesentlichen Bestandteile des Kristallgitters (Al, Ga, In, N), auch wenn diese teilweise durch geringe Mengen weiterer Stoffe ersetzt sein können.

Ein "III/V-Verbindungshalbleitermaterialien auf der Basis von GaP" bedeutet in diesem Zusammenhang, dass ein derart bezeichnetes Material vorzugsweise $Al_nGa_mIn_{1-n-m}P$ umfasst, wobei $0 \leq n \leq 1$, $0 \leq m \leq 1$ und $n+m \leq 1$. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des Materials im Wesentlichen nicht ändern. Obige Formel beinhaltet der Einfachheit halber jedoch nur die wesentlichen Bestandteile des Kristallgitters (Al, Ga, In, P), auch wenn diese teilweise durch geringe Mengen weiterer Stoffe ersetzt sein können.

Ein "III/V-Verbindungshalbleitermaterialien auf der Basis von GaAs" bedeutet in diesem Zusammenhang, dass ein derart bezeichnetes Material vorzugsweise $Al_nGa_mIn_{1-n-m}As$ umfasst, wobei $0 \leq n \leq 1$, $0 \leq m \leq 1$ und $n+m \leq 1$. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des Materials im Wesentlichen nicht ändern. Obige Formel beinhaltet der Einfachheit halber jedoch nur die wesentlichen Bestandteile des Kristallgitters (Al, Ga, In, As), auch wenn diese teilweise durch geringe Mengen weiterer Stoffe ersetzt sein können.

Besonders bevorzugt eignet sich das erfindungsgemäße reflektierende Schichtsystem zur Anwendung in einem Dünnfilm-Leuchtdiodenchip (Dünnfilm-LED-Chip), da sich der reflektierende Schichtaufbau hier im Inneren des Chips befindet und ein mechanisch stabiler Zusammenhalt des Stapels für Funktion und Zuverlässigkeit des Halbleiterchips wesentlich ist.

Ein Dünnfilm-LED-Chip zeichnet sich insbesondere durch folgende charakteristische Merkmale aus:

- an einer zu einem Trägerelement hin gewandten ersten Hauptfläche einer aktiven Epitaxieschichtenfolge, die elektromagnetische Strahlung erzeugen kann, ist eine reflektierende Schicht aufgebracht oder ausgebildet, die zumindest einen Teil der in der Epitaxieschichtenfolge erzeugten elektromagnetischen Strahlung in diese zurückreflektiert; und

- die Epitaxieschichtenfolge weist eine Dicke im Bereich von 20μm oder weniger, insbesondere im Bereich von 10 μm auf.

Vorzugsweise enthält die Epitaxieschichtenfolge mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben.

Ein Dünnfilm-Leuchtdioden-Chip ist in guter Näherung ein Lambert'scher Oberflächenstrahler.

Alle oder einige Schichten des reflektierenden Schichtsystems können mit Hilfe eines Chemical-Vapour-Deposition-Verfahrens (CVD-Verfahren) abgeschieden werden. Hierbei kann es sich beispielsweise um ein Plasma-Enhanced-Chemical-Vapour-Deposition-Verfahren (PECVD-Verfahren) oder um ein Low-Pressure-Chemical-Vapour-Deposition-Verfahren (LPCVD-Verfahren) handeln.

Einflussfaktoren für die Abscheidung von Phosphosilikatglasfilmen sind in der Druckschrift Baliga et al, 1973 (B. J. Baliga und S.K. Ghandhi, 1973 J. Appl. Phys. 44, 3, S990 ) enthalten.

Weitere Vorteile, vorteilhafte Ausführungen und Weiterbildungen des reflektierenden Schichtsystems und des Verfahrens zu seiner Herstellung ergeben sich aus den im Folgenden beschriebenen Ausführungsbeispielen, die anhand der Figuren 1a bis 1c, 2a bis 2b, 3 und 4 erläutert werden.

Es zeigen:

Figuren 1a bis 1b, schematische Schnitt-Darstellungen reflektierender Schichtsysteme auf einer III/V-Verbindungshalbleiteroberfläche,

Figur 1c, eine schematische Schnittdarstellung eines reflektierenden Schichtsystems auf einer strukturierten III/V-Verbindungshalbleiteroberfläche,

Figuren 2a bis 2b, schematische Schnitt-Darstellungen reflektierender Schichtsysteme auf einer strukturierten III/V-Verbindungshalbleiteroberfläche mit unterschiedlichen elektrischen Kontaktstellen,

Figur 3, ein Diagramm, in dem die integralen Reflektivitäten von Schichtabfolgen bestehend aus unterschiedlichen dielektrischen und metallischen Schichten auf einem Substrat mit Brechungsindex n=3.4 in Abhängigkeit der Dicke der dielektrischen Schicht aufgetragen sind, und

Figur 4, ein Diagramm, in dem die integralen Reflektivität eines Schichtsystems, das eine dielektrische Schicht aus Siliziumnitrid und eine metallische Schicht aus Gold auf einem Substrat mit Brechungsindex n=3.4 beinhaltet, in Abhängigkeit der Wellenlänge der elektromagnetischen Strahlung aufgetragen sind.

In den Ausführungsbeispielen und Figuren sind gleiche oder gleichwirkende Bestandteile jeweils mit den gleichen Bezugzeichen versehen. Die dargestellten Elemente der Figuren, insbesondere die Dicken von dargestellten Schichten sind nicht als maßstabsgerecht anzusehen. Vielmehr können sie zum besseren Verständnis teilweise übertrieben groß dargestellt sein.

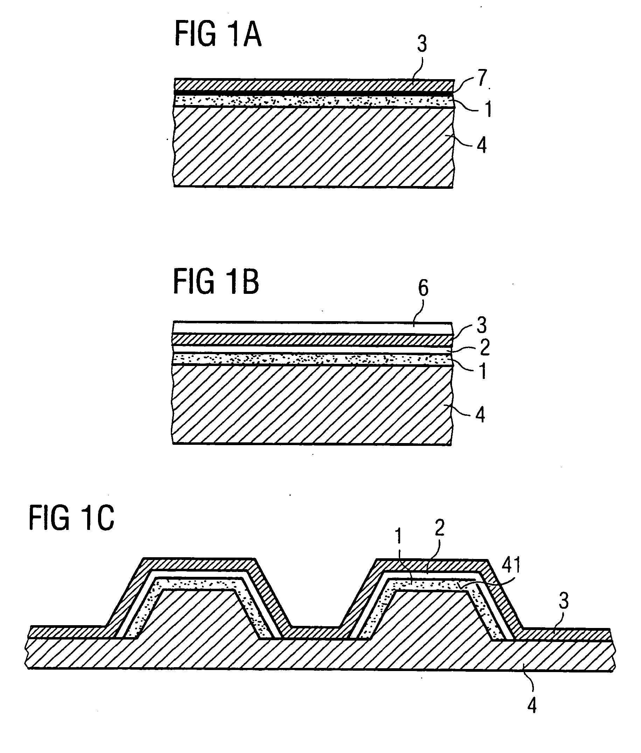

Das vorliegend nicht beanspruchte reflektierende Schichtsystem gemäß Figur 1a weist auf einem III/V-Verbindungshalbleitermaterial 4 eine dielektrische Schicht 1 aus PSG-Material auf, dessen Phosphatgehalt vorzugsweise im Bereich von etwa 20% liegt, um den thermischen Ausdehnungskoeffizienten der dielektrischen Schicht 1 an den des III/V-Verbindungshalbleitermaterials 4 anzupassen. Die Variation des thermischen Ausdehnungskoeffizienten von Phosphosilikatglas bei Änderung des Phosphatgehaltes ist in der Druckschrift B.J. Baliga und S.K. Ghandhi, 1974, IEEE Trans. Electron. Dev., ED21, 7, S. 410-764 beschrieben. Von dem III/V-Verbindungshalbleitermaterials 4 gesehen, ist der dielektrischen Schicht 1 eine metallische Schicht 3 nachgeordnet, die ein Metall enthält, wie zum Beispiel Gold, Zink, Silber und/oder Aluminium. Typische Schichtdicken sind hierbei 700 nm für die dielektrische Schicht 1 und 600 nm für die metallische Schicht 3. Unter der metallischen Schicht 3 kann sich eine haftvermittelnde Schicht 7 befinden, die beispielsweise Cr oder Ti enthält.

Bei dem reflektierenden Schichtsystem gemäß Figur 1b, befindet sich zwischen der PSG-Schicht 1 und der metallischen Schicht 3 eine Kapselungsschicht 2, z.B. aus Siliziumnitrid oder Siliziumoxynitrid, die die PSG-Schicht 1 gegenüber Feuchtigkeit und anderen negativen Einflüssen aus der Umgebung kapselt. Eine solche Kapselungsschicht kann typischerweise eine Dicke von 50 nm besitzen.

Als Sperrschicht 6 kann noch eine weitere Schicht, die beispielsweise TiW:N, Ni, Nb, Pt, Ni:V, TaN, TiN enthält, auf das reflektierende Schichtsystem aufgebracht sein. Eine solche Sperrschicht 6 hat die Aufgabe das reflektierende Schichtsystem oder einzelne Schichten des reflektierenden Schichtsystems vor Einflüssen aus der Umgebung oder nachfolgender Prozesse zu schützen.

Insbesondere TiW:N kann als Sperrschicht 6 mit einer typischen Dicke von 200 nm auf dieses Schichtsystem aufgebracht sein.

Das reflektierende Schichtsystem gemäß Figur 1c befindet sich auf einem mit Pyramidenstümpfen strukturierten III/V-Verbindungshalbleitermaterial. Diese sind mit einer dielektrischen Schicht 1 ummantelt, die Phosphosilikatglas enthält, die wiederum mit einer weiteren Kapselungsschicht 2 gekapselt ist. Hierauf befindet sich eine durchgehende metallische Schicht 3.

Diese Anordnung führt zu einer verbesserten Kapselung der dielektrischen Schicht 1, da diese keine freiliegenden Bereiche aufweist, die mit Feuchtigkeit aus der Chipumgebung in Kontakt kommen können, wie beispielsweise seitliche Kanten. Auch die metallische Schicht 3 trägt zur Kapselung der ersten Schicht 1 bei. Eine optimierte Spiegelwirkung wird durch dieses Schichtsystem gezielt nur an den Pyramidenstümpfen 41 erzielt.

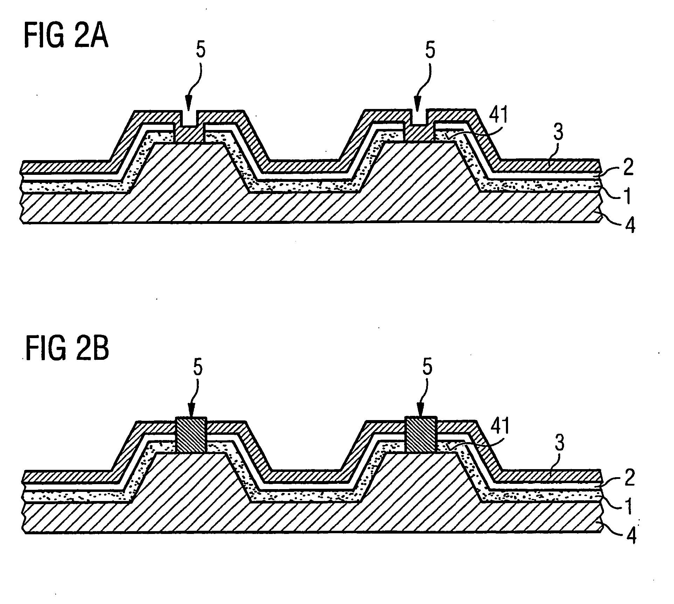

Zur elektrischen Kontaktierung des III/V-Halbleitermaterials 4 durch das reflektierende Schichtsystem können auf den Pyramidenstümpfen 41 elektrische Kontaktstellen 5 ausgebildet sein. In Figur 2a sind beispielsweise Kontaktstellen 5 schematisch dargestellt, die dadurch hergestellt werden, dass in die dielektrische Schicht 1 und die Kapselungsschicht 2 Löcher geätzt werden und anschließend die metallische Schicht 3 aufgebracht wird. Hierbei füllt das metallische Material die Löcher vertikal zumindest teilweise und horizontal ganzflächig aus wodurch die metallische Schicht 3 durchgehend mit dem III/V-Verbindungshalbleitersubstrat 4 elektrisch leitend verbunden wird.

Alternativ zum beschriebenen photolithographischen Strukturierungsverfahren ist es auch möglich, dass ein Laserverfahren zur Herstellung der Kontaktstellen 5 Verwendung findet. Dabei werden zum Beispiel in der dielektrischen Schicht 1 und - falls vorhanden - in der Kapselungsschicht 2 mit Hilfe eines Lasers Fenster für die Kontaktstellen 5 erzeugt. In den Fenstern liegt das Substrat 4 frei. Die Fester weisen beispielsweise einen Durchmesser von 1 $\mu$m bis 20 $\mu$m auf, so dass bei den nachfolgenden Prozessschritten Kontaktstellen 5 mit einem Durchmesser dieser Größe entstehen. Nachfolgend wird die metallische Schicht 3 abgeschieden. Dabei füllt das metallische Material die Fenster vertikal zumindest teilweise und horizontal vorzugsweise ganzflächig aus, wodurch die metallische Schicht 3 durchgehend mit dem III/V-Verbindungshalbleitersubstrat 4 elektrisch leitend verbunden wird.

In Figur 2b ist eine weitere mögliche Ausprägung der elektrischen Kontaktstellen 5 schematisch dargestellt. Im Unterschied zu den Kontaktstellen 5 nach dem Ausführungsbeispiel gemäß Figur 2a entspricht die vertikale Ausdehnung dieser Kontaktstellen 5 mindestens der Höhe der dielektrischen Schicht 1 und der Kapselungsschicht 2.

Solche elektrischen Kontaktstellen 5 können beispielsweise hergestellt werden, wie im Folgenden beschrieben:

In einem ersten Schritt werden in die dielektrische Schicht 1 und die Kapselungsschicht 2 mittels einer strukturierten Maske, beispielsweise bestehend aus einer photosensitive Lackschicht, Fenster für die Kontaktstellen 5 geätzt. Nachfolgend wird hierauf die metallische Schicht 3 abgeschieden, so dass das metallische Material die Fenster vertikal zumindest teilweise und horizontal ganzflächig ausfüllt. In einem nachfolgenden Schritt wird die Lackschicht z.B. mit Hilfe eines geeigneten Lösungsmittels entfernt, wobei auch die Teile der metallischen Schicht 3 abgehoben werden, die sich auf der Lackschicht befinden, so dass nur noch die elektrischen Kontaktstellen 5 verbleiben. Zur Vervollständigung des reflektierenden Schichtsystems kann nun die metallische Schicht 3 aufgebracht werden, die eine elektrische Querverbindung zwischen den einzelnen Kontaktstellen 5 herstellt.

Alternativ zur Strukturierung der Kontaktstellen 5 mittels eines photolithographischen Verfahrens ist auch in diesem Fall eine Strukturierung der Kontaktstellen 5 mittels des oben beschriebenen Laserverfahrens möglich.

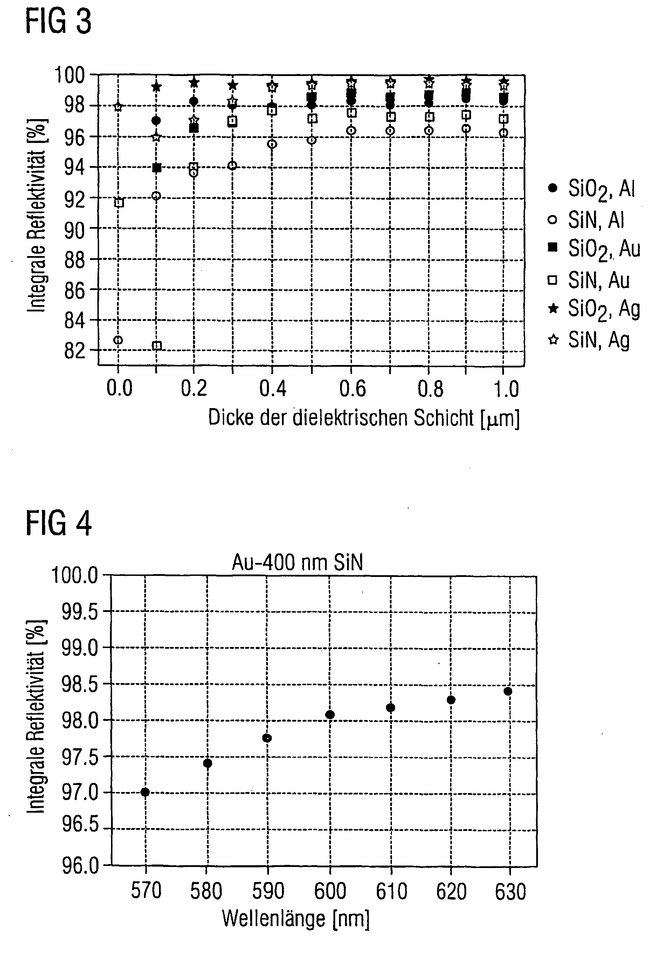

Reflektierende Schichtsysteme bestehend aus einer dielektrischen Schicht 1 und einer Metallschicht 3 auf einem Substrat 4 mit Brechungsindex n=3.4, wie beispielsweise einem Halbleitermaterial, besitzen eine erhöhte integrale Reflektivität, wenn die dielektrische Schicht 1 aus Siliziumdioxid anstelle von Siliziumnitrid besteht (vergleiche Figur 3). Das Substrat 4 kann hierbei z.B. aus einem Halbleitermaterial mit Brechungsindex 3.4 bestehen.

Figur 4 zeigt Werte der integralen Reflektivität in Abhängigkeit von der Wellenlänge der reflektierten elektromagnetischen Strahlung eines Schichtsystems bestehend aus einer Schicht Siliziumnitrid und einer Schicht Gold der Dicke 400 nm auf einem Substrat 4 mit Brechungsindex 3.4, z.B. aus einem Halbleitermaterial. Hierbei ist zu erkennen, dass die integrale Reflektivität des Schichtsystems mit der Wellenlänge der reflektierten elektromagnetischen Strahlung steigt.

Phosphosilikatglas (dielektrische Schicht 1) kann mittels eines CVD-Verfahrens auf dem III/V-Verbindungshalbleitermaterial abgeschieden werden, wie z.B. mit einem PECVD-Verfahren. Bei einem PECVD-Verfahren eingesetzte Gasgemische enthalten z.B. reinen Sauerstoff oder Distickstoffmonoxid als Sauerstofflieferant, Phosphin oder Trimethylphosphite als Phosphorlieferant und Silan, Disilan, Dichlorsilan, Diethylsilan oder Tetraethoxysilan als Siliziumlieferant. Als Verdünnungsgas können dem jeweiligen Gemisch Argon oder Stickstoff zugesetzt sein. Besonders häufig verwendete Gasgemische enthalten Silan, Sauerstoff und Phosphin oder Tetraethoxysilan, Sauerstoff und Phosphin. Die so abgeschiedene PSG-Schicht (dielektrische Schicht 1) kann in einem nächsten Prozessschritt in situ mit Siliziumnitrid (Kapselungsschicht 2) gekapselt werden. In einem weiteren Schritt wird nun die Metallschicht (metallische Schicht 3) aufgebracht. Alternativ kann auch ein LPCVD-Verfahren eingesetzt werden.

Das reflektierende Schichtsystem, wie in den Ausführungsbeispielen beschrieben, kann auf einem III/V-Verbindungshalbleitermaterial 4 basierend auf GaN, GaAs oder GaN aufgebracht werden, das beispielsweise eine aktive Photonen emittierende Schichtenfolge enthält. Insbesondere kann es sich hierbei um die Photonen emittierende aktive Schichtenfolge eines Dünnfilm-LED-Chips handeln.

Eine Photonen emittierende aktive Schichtenfolge kann beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Strukur) aufweisen. Solche Strukturen sind dem Fachmann bekannt und werden von daher an dieser Stelle nicht näher erläutert. Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit unter Anderem Quantentröge, Quantendrähte und Quantenpunkte und jede Kombination dieser Strukturen.

**Patentansprüche**

1. Reflektierendes Schichtsystem aufgebracht auf ein Verbindungshalbleitermaterial (4) mit einer dielektrischen Schicht (1) auf dem Verbindungshalbleitermaterial (4), die Phosphosilikatglas enthält, und einer Schicht (3), die ein Metall enthält und sich auf der dielektrischen Schicht (1) befindet, **gekennzeichnet durch** eine Verkapselungsschicht (2) zwischen der dielektrischen Schicht (1) und der metallischen Schicht (3), die die dielektrische Schicht (1) gegen Feuchtigkeitszutritt aus der Umgebung verkapselt.

2. Reflektierendes Schichtsystem nach Anspruch 1, **gekennzeichnet durch** eine Verkapselungsschicht (2), die Siliziumnitrid enthält.

3. Reflektierendes Schichtsystem nach Anspruch 1, **gekennzeichnet durch** eine Verkapselungsschicht (2), die $SiO_xN_y$, enthält, mit $x,y \in$ [0;1] und x+y=1.

4. Reflektierendes Schichtsystem nach einem der vorhergehenden Ansprüche, **dadurch gekennzeichnet,** **dass** der Phosphatgehalt der dielektrischen Schicht (1) so gewählt ist, dass der thermische Ausdehnungskoeffizient der dielektrischen Schicht an den des Verbindungshalbleitermaterials (4) angepasst ist.

5. Reflektierendes Schichtsystem nach einem der vorhergehenden Ansprüche, **dadurch gekennzeichnet,** **dass** die metallische Schicht (3) mindestens ein Material aus der Gruppe bestehend aus Gold, Zink, Silber und Aluminium enthält.

6. Reflektierendes Schichtsystem nach einem der vorhergehenden Ansprüche, **dadurch gekennzeichnet,** **dass** sich zwischen der metallischen Schicht (3) und der dielektrischen Schicht (1) eine weitere, haftvermittelnde Schicht (7) befindet.

7. Reflektierendes Schichtsystem nach Anspruch 6, **dadurch gekennzeichnet,** **dass** die weitere, haftvermittelnde Schicht (7) zwischen der metallischen Schicht (3) und der dielektrischen Schicht (1) Cr oder Ti enthält.

8. Reflektierendes Schichtsystem nach einem der vorhergehenden Ansprüche, **dadurch gekennzeichnet,** **dass** sich eine weitere Sperrschicht (6) auf der metallischen Schicht (3) befindet, die mindestens ein Material aus der Gruppe enthält, die durch TiW:N, Ni, Nb, Pt, Ni:V, TaN und TiN gebildet wird.

9. Reflektierendes Schichtsystem nach einem der vorhergehenden Ansprüche, **dadurch gekennzeichnet,** **dass** elektrisch leitfähige Kontaktstellen (5) durch das reflektierende Schichtsystem hindurch ausgebildet sind, die eine elektrisch leitfähige Verbindung von dem Halbleitermaterial zu der obersten Schicht herstellen.

10. Reflektierendes Schichtsystem nach einem der vorhergehenden Ansprüche, **dadurch gekennzeichnet,** **dass** eine oder mehrere der Schichten und/oder die Oberfläche des Verbindungshalbleitermaterials (4) strukturiert sind.

11. Reflektierendes Schichtsystem nach einem der vorhergehenden Ansprüche, **dadurch gekennzeichnet,** **dass** das Verbindungshalbleitermaterial mindestens ein Material enthält, das auf GaAs, GaN oder GaP basiert.

12. Leuchtdioden-Chip **dadurch gekennzeichnet,** **dass** dieser ein reflektierendes Schichtsystem nach einem der vorhergehenden Ansprüche beinhaltet.

13. Verfahren zur Herstellung eines reflektierenden Schichtsystems nach Anspruch 9, wobei die Kontaktstellen (5) mittels Ätzen erzeugt werden.

14. Verfahren zur Herstellung eines reflektierenden Schichtsystems nach Anspruch 9, wobei die Kontaktstellen (5) mit Hilfe eines Lasers erzeugt werden.

**Claims**

1. Reflective layer system applied to a compound semiconductor material (4) comprising a dielectric layer (1) on the compound semiconductor material (4), which dielectric layer contains phosphosilicate glass, and

   comprising a layer (3) containing a metal and situated on the dielectric layer (1),

   **characterized by**

   an encapsulation layer (2) between the dielectric layer (1) and the metallic layer (3), which encapsulates the dielectric layer (1) against ingress of moisture from the surroundings.

2. Reflective layer system according to Claim 1,
   **characterized by**
   an encapsulation layer (2) containing silicon nitride.

3. Reflective layer system according to Claim 1,
   **characterized by**
   an encapsulation layer (2) containing $SiO_xN_y$, where $x,y \in [0;1]$ and $x + y = 1$.

4. Reflective layer system according to any of the preceding claims,
   **characterized in that**
   the phosphate content of the dielectric layer (1) is chosen such that the coefficient of thermal expansion of the dielectric layer is adapted to that of the compound semiconductor material (4).

5. Reflective layer system according to any of the preceding claims,
   **characterized in that**
   the metallic layer (3) contains at least one material from the group consisting of gold, zinc, silver and aluminium.

6. Reflective layer system according to any of the preceding claims,
   **characterized in that**
   a further, adhesion-promoting layer (7) is situated between the metallic layer (3) and the dielectric layer (1).

7. Reflective layer system according to Claim 6,
   **characterized in that**
   the further, adhesion-promoting layer (7) between the metallic layer (3) and the dielectric layer (1) contains Cr or Ti.

8. Reflective layer system according to any of the preceding claims,
   **characterized in that**
   a further barrier layer (6) is situated on the metallic layer (3), which contains at least one material from the group formed by TiW:N, Ni, Nb, Pt, Ni:V, TaN and TiN.

9. Reflective layer system according to any of the preceding claims,
   **characterized in that**
   electrically conductive contact locations (5) are formed through the reflective layer system, which produce an electrically conductive connection from the semiconductor material to the topmost layer.

10. Reflective layer system according to any of the preceding claims,
    **characterized in that**
    one or a plurality of the layers and/or the surface of the compound semiconductor material (4) are patterned.

11. Reflective layer system according to any of the preceding claims,
    **characterized in that**
    the compound semiconductor material contains at least one material based on GaAs, GaN or GaP.

12. Light-emitting diode chip, **characterized in that** it comprises a reflective layer system according to any of the preceding claims.

13. Method for producing a reflective layer system according to Claim 9,
    wherein the contact locations (5) are produced by means of etching.

14. Method for producing a reflective layer system according to Claim 9,
    wherein the contact locations (5) are produced with the aid of a laser.

**Revendications**

1. Système de couches réfléchissantes appliqué sur un matériau semi-conducteur composite (4), avec une couche diélectrique (1) contenant du verre de phosphosilicate et se trouvant sur le matériau semi-conducteur composite (4), et

   une couche (3) contenant un métal et se trouvant sur la couche diélectrique (1),

   **caractérisé par**

   une couche d'encapsulation (2) située entre la couche diélectrique (1) et la couche métallique (3), qui protège la couche diélectrique (1) contre l'humidité ambiante.

2. Système de couches réfléchissantes selon la revendication 1,
   **caractérisé par**
   une couche d'encapsulation (2) contenant du nitrure de silicium.

**3.** Système de couches réfléchissantes selon la revendication 1,
**caractérisé par**
une couche d'encapsulation (2) contenant du $SiO_x$-$N_y$, avec $x,y \in [0;1]$ et $x+y=1$.

**4.** Système de couches réfléchissantes selon l'une des revendications précédentes,
**caractérisé en ce que**
la teneur en phosphate de la couche diélectrique (1) est choisie de telle manière que le coefficient d'expansion thermique de la couche diélectrique est adapté à celui du matériau semi-conducteur composite (4).

**5.** Système de couches réfléchissantes selon l'une des revendications précédentes,
**caractérisé en ce que**
la couche métallique (3) contient au moins un matériau issu du groupe comprenant l'or, le zinc, l'argent et l'aluminium.

**6.** Système de couches réfléchissantes selon l'une des revendications précédentes,
**caractérisé en ce que**
une couche supplémentaire de liaison par adhésion (7) est située entre la couche métallique (3) et la couche diélectrique (1).

**7.** Système de couches réfléchissantes selon l'une des revendications précédentes,
**caractérisé en ce que**
la couche supplémentaire de liaison par adhésion (7) située entre la couche métallique (3) et la couche diélectrique (1) contient du Cr ou du Ti.

**8.** Système de couches réfléchissantes selon l'une des revendications précédentes,
**caractérisé en ce que**
une couche supplémentaire de barrage (6) se trouve sur la couche métallique (3), contenant au moins un matériau parmi le groupe formé par TiW:N, Ni, Nb, Pt, Ni:V, TaN et TiN.

**9.** Système de couches réfléchissantes selon l'une des revendications précédentes,
**caractérisé en ce que**
les points de contact électriquement conducteurs (5) sont formés à travers l'ensemble du système de couches réfléchissantes, en créant une liaison électriquement conductrice entre le matériau semi-conducteur et la couche supérieure.

**10.** Système de couches réfléchissantes selon l'une des revendications précédentes,
**caractérisé en ce que**
une ou plusieurs couches et/ou la surface du matériau semi-conducteur composite (4) sont structurées.

**11.** Système de couches réfléchissantes selon l'une des revendications précédentes,
**caractérisé en ce que**
le matériau semi-conducteur composite contient au moins un matériau à base de GaAs, de GaN ou de GaP.

**12.** Puce à diode électroluminescente, **caractérisée en ce qu'**elle contient un système de couches réfléchissantes selon l'une quelconque des revendications précédentes.

**13.** Procédé pour la fabrication d'un système de couches réfléchissantes selon la revendication 9,
dans lequel les points de contact (5) sont réalisés par attaque chimique.

**14.** Procédé pour la fabrication d'un système de couches réfléchissantes selon la revendication 9,
dans lequel les points de contact (5) sont réalisés au laser.

FIG 1A

FIG 1B

FIG 1C

FIG 2A

FIG 2B

## FIG 3

**Legend:**
- ● SiO$_2$, Al
- ○ SiN, Al
- ■ SiO$_2$, Au
- □ SiN, Au
- ★ SiO$_2$, Ag
- ☆ SiN, Ag

X-axis: Dicke der dielektrischen Schicht [μm]
Y-axis: Integrale Reflektivität [%]

## FIG 4

Au-400 nm SiN

X-axis: Wellenlänge [nm]
Y-axis: Integrale Reflektivität [%]

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4122486 A

**In der Beschreibung aufgeführte Nicht-Patentliteratur**

- Physical Properties of Phosphorus-Silica Glass in Fiber Preforms. *Journal of Communications Technology and Electronics,* 1998, vol. 43 (4), 480-484
- **I. Schnitzer et al.** *Appl. Phys. Lett.,* 18. Oktober 1993, vol. 63 (16), 2174-2176
- **B. J. Baliga ; S.K. Ghandhi.** *J. Appl. Phys.,* 1973, vol. 44 (3), 990
- **Druckschrift B.J. Baliga ; S.K. Ghandhi.** *IEEE Trans. Electron. Dev.,* 1974, vol. ED21 (7), 410-764